(19) Europäisches Patentamt

European Patent Office

Office européen des brevets

(11) **EP 0 935 263 B1**

(12) **EUROPEAN PATENT SPECIFICATION**

(45) Date of publication and mention
of the grant of the patent:
**26.05.2004 Bulletin 2004/22**

(51) Int Cl.⁷: **H01F 19/04**, H01F 27/28,
H03H 7/38

(21) Application number: **99300789.7**

(22) Date of filing: **03.02.1999**

(54) **Method of operating a coreless printed-circuit-board (PCB) transformer**

Betriebstechniken für kernlose PCB-Transformatoren

Procédé d'utilisation d'un transformateur sans noyau pour circuit imprimé

(84) Designated Contracting States:
**AT CH DE DK FI FR GB IE IT LI SE**

(30) Priority: **05.02.1998 US 18871**

(43) Date of publication of application:
**11.08.1999 Bulletin 1999/32**

(73) Proprietor: **City University of Hong Kong
Hongkong (CN)**

(72) Inventors:
• **Hui, Shu Yuen Ron, Dep. of Electr. Engineering
Kowloon (HK)**
• **Tang, Sai Chun
Shatin, New Territories (HK)**

(74) Representative: **Findlay, Alice Rosemary
Lloyd Wise
Commonwealth House,
1-19 New Oxford Street
London WC1A 1LW (GB)**

(56) References cited:
**EP-A- 0 147 499**

• **HUI S Y R ET AL: "Coreless PCB-based
transformers for power MOSFET/IGBT gate drive
circuits" PEPSC97 RECORD. 28TH ANNUAL
IEEE POWER ELECTRONICS SPECIALISTS
CONFERENCE (CAT. NO.97CH36043), PESC97.
RECORD 28TH ANNUAL IEEE POWER
ELECTRONICS SPECIALISTS CONFERENCE.
FORMERLY POWER CONDITIONING
SPECIALISTS CONFERENCE 1970-71. POWER
PROCESSING AND , pages 1171-1176 vol.2,
XP002118944 1997, New York, NY, USA, IEEE,
USA ISBN: 0-7803-3840-5**
• **PATENT ABSTRACTS OF JAPAN vol. 016, no.
158 (E-1191), 17 April 1992 (1992-04-17) & JP 04
010680 A (MATSUSHITA ELECTRIC IND CO
LTD), 14 January 1992 (1992-01-14)**

EP 0 935 263 B1

**Description**

This invention relates to PCB-based transformers, and in particular to coreless PCB-based transformers and to optimal operating techniques for such transformers.

Transformers are commonly used for energy and signal transfer and for providing electrical isolation. Commonly used magnetic core-based transformers require a manual winding process, which not only increases the labour cost but also prohibits full automation of the circuits in the manufacturing process. This disadvantage has prompted research efforts on making planar transformer and/or inductor windings on printed circuit boards (PCB). In an industrial research, a PCB transformer has been proposed for isolated gate drive circuits for power MOSFETs. The transformer windings are printed on a double-sided PCB. The winding pattern has a hole in the center so that a U-I core set or a U-U core set can be glued together to form a closed magnetic path. Recently, it has been demonstrated *(S.Y.R. Hui, H. Chung, and S.C. Tang: "Coreless PCB-based transformers for power MOSFET/IGBT gate drive circuits", IEEE Power Electronics Specialists Conference, St.Louis USA, June 1997, pp1171-1178)* that coreless PCB transformers have desirable characteristics and can be employed for energy and digital signal transfer for low power applications (say less than SOW) in the high frequency range from a few hundreds of Kilo-Hertz to a few Mega-Hertz. Because there is no need to have the central gap area, coreless PCB transformers occupy a much smaller area than the core-based PCB transformers. In addition, dielectric breakdown voltage of PCB typically ranges from 15kV to 40kV - a voltage range that is much higher than that of optocouplers (typically 1.5kV to 7.5kV).

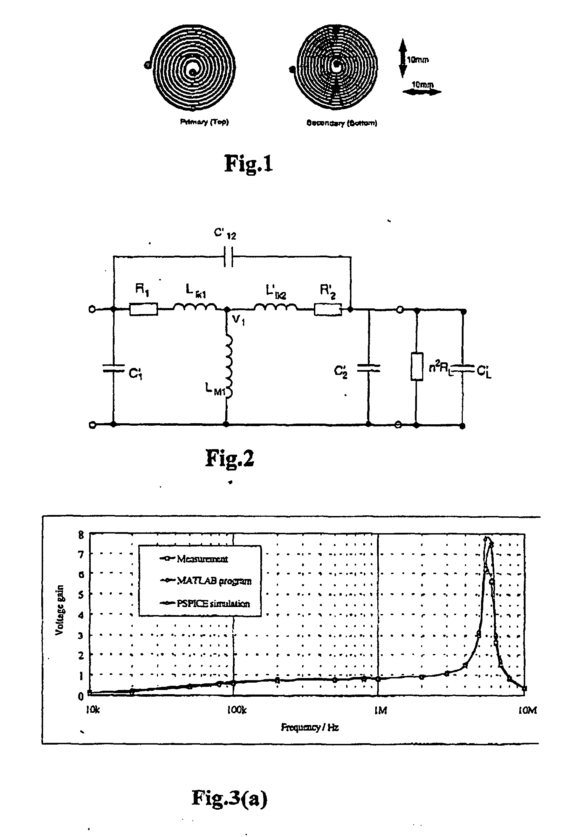

In *Hui et al*, several coreless transformers were used for isolation in a 'direct' gate drive circuit that can switch power MOSFETs and IGBTs at high frequency (from about 300kHz to 2 MHz). An example of such a coreless PCB-based transformer is shown in Fig.1. The circuit model (Fig.2) shows that the coreless PCB transformers have good features in the high frequency range from a few hundreds of kilo-Hertz to a few Mega-Hertz, but become less attractive in the low frequency range smaller than 300kHz. The main reason for this limitation is that the magnetizing reactance ($X_m = \omega L_m$) of the coreless PCB transformers decreases with decreasing frequency. Thus, the voltage gain is low in the low-frequency range. At extremely low switching frequency (say a few Hertz), the printed planar windings with only a few turns (say 10 turns) behave almost like short-circuit paths, making the primary winding current unacceptably large and the voltage gain unattractively low. The power loss of the coreless PCB gate drive circuits includes the power loss in the transformer and the power loss in the gate drive circuit components. At low operating frequency, the transformer loss becomes excessive. In general, the overall power consumption decreases with increasing operating frequency until the switching loss in the electronics and the conduction loss of the printed windings (due to skin effect) become dominant.

It is an object of the present invention therefore to provide optimal operating techniques for coreless PCB transformers (1) under minimum input power requirement (such as in a gate drive circuit for a power MOSFET) and (2) under maximum energy efficiency (such as in a power converter).

The present invention is therefore characterized in that a coreless transformer is operated at an optimum frequency which is at or near the frequency at which the impedance of a transformer equivalent circuit is at its maximum and which is less than the resonant frequency of the transformer.

The transformer may be operated directly in a frequency range of from about 100kHz to about 20MHz. If it is desired to operate at lower frequencies the transformer may be operated by a high-frequency carrier signal modulated by a low-frequency switching signal, the carrier signal being at a frequency corresponding to the maximum impedance of the transformer. Preferably in this embodiment the carrier signal is at a frequency of between 300kHz and 20MHz and the switching signal is at a frequency between DC and 300kHz.

One possible application for an embodiment of the invention is as a method for driving a power MOSFET or IGBT device in which a transformer is used to isolate the device from an input power supply. At high frequencies the gate may be driven directly by the transformer. If it is desired to operate the device at a lower frequency, however, a modulation technique may be used to modulate a high-frequency carrier signal input to the transformer, the carrier signal being demodulated after said transformer to drive the gate at the low switching frequency, the carrier signal being at an optimum frequency corresponding to the maximum impedance of the transformer.

For an application such as in a power MOSFET or IGBT device the optimum frequency corresponds to a minimum power input frequency. For other applications other criteria may apply for the optimum frequency. For example, if the transformer is used as part of a power converter apparatus the optimum frequency is a maximum efficiency frequency which is found to be slightly lower than the frequency at which the transformer impedance is maximum.

Some embodiments of the present invention will now be described by way of example and with reference to the accompanying drawings, in which:-

Fig. shows the typical primary and secondary windings of a coreless PCB-based transformer,
Fig.2 shows the equivalent circuit of a PCB-based transformer with parallel capacitive/resistive load,
Fig.3 is a plot showing calculated, simulated and measured (a) voltage gain and (b) phase shift of the transformer of Fig. 1 with a capacitive load,

Fig.4 shows the primary and secondary windings of another coreless PCB-based transformer,

Fig.5 is a high-frequency equivalent circuit model of the coreless PCB-based transformer of Fig.4,

Fig.6 is a plot showing predicted (solid-line) and measured (dotted) input impedance against operating frequency of the transformer of Fig.4,

Figs.7(a) and (b) are plots showing the predicted and measured (a) voltage gain and (b) phase shift,

Fig.8 is a circuit diagram of a modulated gate drive circuit with smooth duty cycle transition from 0 to 1 known from the prior art,

Fig.9 is a circuit diagram of a modified modulated gate drive circuit using a coreless PCB-based transformer,

Figs.10(a) and (b) are plots showing (a) measured input and output signals of the circuit of Fig.9 at $f_{sw}$ = 1Hz, and (b) measured input, carrier and output signals of the circuit of Fig.9 at $f_{sw}$ = 300kHz,

Figs.11(a) and (b) are plots showing measured $V_{gs}$ (upper) and $V_{ds}$ (lower) of a power MOSFET at (a)$f_{sw}l$ = 1Hz and (b)$f_{sw}$ = 300kHz,

Fig.12 is a plot showing measured $V_{gs}$ (upper) and $I_d$ (lower) of the power MOSFET *at $f_{sw}$* = 100kHz,

Fig.13 is a plot showing measured input current of the gate drive circuit against carrier frequency under the worst case condition of duty cycle 1.0,

Fig.14 shows the primary and secondary windings of another coreless PCB-based transformer,

Fig.15 shows the equivalent circuit of the transformer of Fig. 14,

Fig. 16 is a plot of the gain of the transformer of Fig. 14 against operating frequency with $C_2$ = 100pF,

Fig.17 is a plot of the input impedance of the coreless PCB-based transformer of Fig.14 against operating frequency with $C_2$ = 100pF,

Fig.18 is a plot of the energy efficiency of the transformer of Fig.14 against operating frequency with $C_2$ = 100pF,

Fig.19 is a plot of the gain of the transformer of Fig.14 against operating frequency with $C_2$ = 1000pF,

Fig.20 is a plot of the input impedance of the transformer of Fig.14 against operating frequency with $C_2$ = 1000pF, and

Fig.21 is a plot of the energy efficiency of the transformer of Fig.14 against operating frequency with $C_2$ = 1000pF.

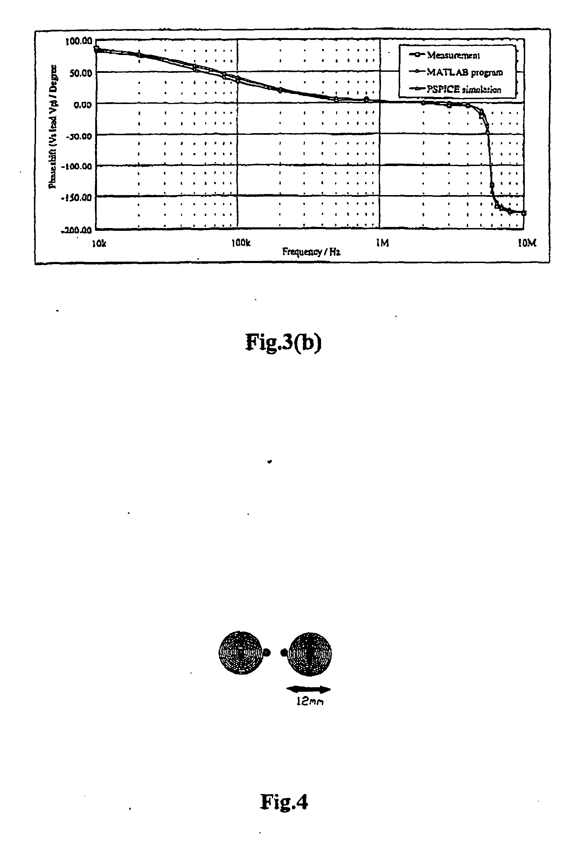

A coreless transformer of the type shown in Fig. 1 was fabricated on a PCB and the thickness of the PCB is 1.55 mm. The circuit model (Fig.2) was implemented in PSpice and the circuit equations (1) and (2) (to be discussed later) were also solved in MATLAB [10], the frequency response of the transformer of Fig. 1 is shown in Fig.3, where

$R_1$ is the primary winding resistance,

$R_2$ is the secondary winding resistance referred to the primary,

$R_L$ is the resistive load,

$L_{lk1}$ is the primary leakage inductance,

$L_{lk2}'$ is the secondary leakage inductance referred to the primary,

$L_{M1}$ is the primary mutual inductance,

$C_1$ is the primary winding capacitance,

$C_2'$ is the secondary winding capacitance referred to the primary,

$C_{12}$ is the capacitance between primary and secondary windings, and

$n$ is the turn ratio.

In general, the voltage gain of the transformer of Fig. is sufficiently high (>0.8 in this example) for gate drive application from 200 kHz to about 5 MHz. Primarily due to the load capacitance and the equivalent leakage inductance of the transformer, resonance occurs at about 5.5 MHz for the transformer of Fig.1. In the Mega-Hertz range below the resonance frequency, the phase shift is very small.

Observation of this typical frequency response leads to the following important points that can be considered to operate the coreless transformer in an optimal manner:

(i) The voltage gain of the transformer drops to zero beyond the resonant frequency. Thus the useable frequency range must be below the resonant frequency.

(ii) The operating frequency of the coreless transformer should be near or at the high-frequency end of the useable operating range (so that the magnetizing reactance is large) in order to minimize the input current and hence the power of the gate drive circuits.

(iii)Near the resonance region (just below the resonant frequency), the voltage gain is higher than the rest of the operating range. One can take advantage of this high-gain region in order to achieve fast switching time for power MOSFETs or IGBTs.

(iv)The optimal operating frequency, which combines the benefits of (i) and (ii), should be the frequency at which the impedance of the overall transformer isolated equivalent circuit is at its maximum. At (or near) this maximum-impedance frequency, the power consumption of the coreless PCB transformer gate drive can be minimized.

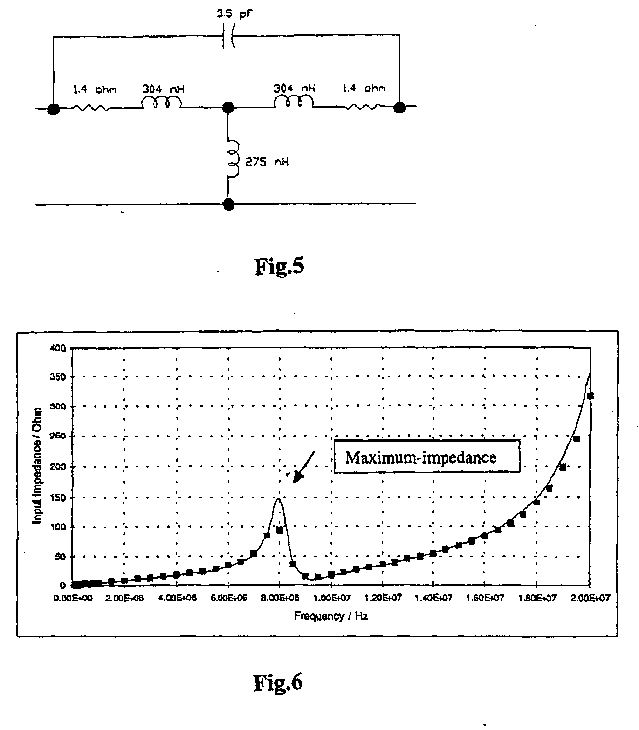

The dimension of a new coreless PCB transformer is shown in Fig.4. The area of the transfomer in Fig.4 is roughly 25% of that of the transformer of Fig.1, and is much smaller than a typical pulse transformer. Because the intra-winding capacitance of the transformer of Fig.4 is negligible (when measured at 10MHz), the circuit model can be simplified as shown in Fig. 5. The inductive components of the circuit model are calculated by the analytical method proposed by Hurley and Duffy [*W.G.Hurley and M.C.Duffy, "Calculation of self and mutual impedances in planar magnetic structures ", IEEE Trans. On Magnetics, Vol.31, No.4, July 1995, pp.2416-2422*] and are also computed using Ansoft 2-dimensional finite-element EM field solver. The width and height of the copper track are 0.22mm and 0.025mm, respectively. The distance between adjacent tracks is about 0.28mm. The number of turns for the primary and secondary printed windings is 10. The interwinding capacitor $C_{12}$ is calculated by assuming that each coil is a solid conducting plain. The parameters are measured at 10 MHz with a HP 4194A impedance analyzer. The calculated $C_{12}$ is 3.5pF, which is the same as the measured value. The calculated, computed and measured values of the inductive parameters are listed in Table I. The inductance of the leads connected to the windings is found to be about 36nH. Excluding this external inductance, the corrected measured inductive component values are given in Table I. It is found that these values are in good agreement in general. The difference in the calculated and measured magnetizing inductance is only about 3.3%.

Table I:

| Calculated, computed and measured values for inductive circuit components | | | |
|---|---|---|---|
| | Hurley and Duffy's method | Ansoft | Measurements |
| $L_{lk1}$ | 267nH | 268nH | 268nH(+36nH) |
| $L_{lk2}$ | 267nH | 268nH | 268nH (+36nH) |
| $L_m$ | 266nH | 262nH | 275nH |

From here onwards, $C_1$ and $C_2$ in the following analysis of optimal gate drive conditions represent the equivalent circuit capacitance that appear in the primary winding and the secondary windings, respectively. Based on this high-frequency model, the voltage gain ($V_2/V_1$) and the input impedance ($Z_{in}$, referred to the primary side) of the coreless transformer can be expressed as follows:

$$\frac{V_2}{V_1} = B = \frac{\frac{1}{X_1} + sC_{12}\ Y_1}{nY} \tag{1}$$

and

$$Z_{in} = \frac{1}{sC''_{12}(1-nB) + \frac{(1-A)}{X_1} + sC''_1} \tag{2}$$

where

$$R'_2 = n^2\ R_2$$

$$L'_{lk2} = n^2 L_{lk2}$$

$$C''_1 = C_1 + \frac{n-1}{n}\ C_{12}$$

$$C''_2 = \frac{1}{n^2} C_2 + \frac{1-n}{n^2} C_{12}$$

$$C''_{12} = \frac{1}{n} C'_{12}$$

$$X_1 = R_1 + sL_{lk1}$$

$$X_2 = R'_2 + SL_{lk2}$$

$$Y_1 = X_2 \left[ \frac{1}{X_1} + \frac{1}{sL_{M1}} \right] + 1$$

$$Y_2 = \frac{1}{X_2} + sC'_{12} + sC'_2 + \frac{1}{n_2 R_L}$$

$$Y = -\frac{1}{X_2} + Y_1 Y_2$$

$$A = \frac{sC''_{12} + \frac{X_2}{X_1} Y_2}{Y}$$

The resonant frequency is given by

$$f_o = \frac{1}{2\pi \sqrt{L_{eq} C_{eq}}} \tag{3}$$

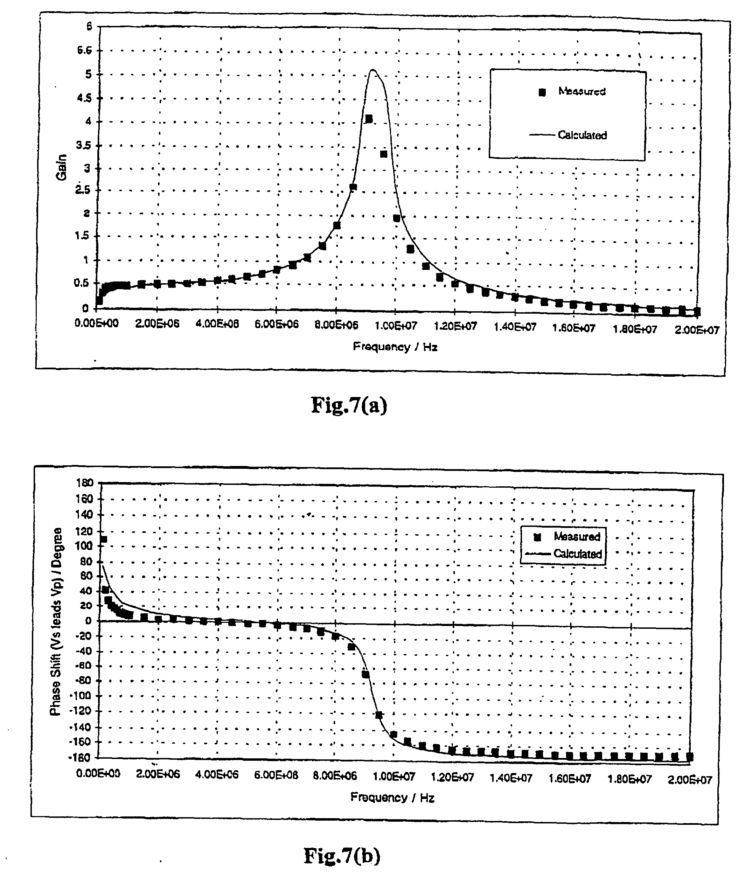

where $L_{eq} = L'_{lk2} + L_{lk1} \parallel L_{M1}$ and $C_{eq} = C'_2 + C'_{12}$. (Here $C_2'$ includes the load capacitance.) If CMOS logic gates are used in the control of the gate drive circuits, the rise and fall times of CMOS at 10V operation are typically 50ns. Thus, its operating frequency is limited to 10 MHz. This frequency limitation is also the limit for the operating frequency of the gate drive circuit including the coreless transformer. In order to analyze the frequency response of the transformer of Fig.4, the primary circuit capacitance and the load capacitance should be included. In this study, the input capacitance $C_1$ is 120pF. (This is a typically output capacitance of a buffer circuit.) The secondary winding is loaded with a resistor of 2kΩ in parallel with a capacitor $C_2$ of 680pF. (Note: this $C_1$ and $C_2$ are not the winding capacitance as in Fig.2.) The choice of this load capacitor $C_2$ gives a resonant frequency to be approximately 9 MHz, which is less than the 10 MHz limit. Using (1) and (2), the predicted and measured variation of the input impedance and the frequency response with operating frequency of the transformer of Fig.4 are plotted in Fig.6 and Fig.7, respectively. These results confirm that the high-frequency coreless transformer model is accurate.

Observation of these plots leads to the following important points:

1. The magnitude of the input impedance peaks at a frequency (termed "maximum-impedance frequency") which is within the useable frequency range and is slightly below the resonant frequency. For the transformer of Fig.4, this frequency is about 8 MHz and the impedance is about 150Ω.
2. The voltage gain at this "maximum-impedance frequency" is high (about 1.8) and the enlarged outage voltage can speed up the switching times of the power devices. It should be noted that, while the careless operation has relatively low magnetic coupling than the core-based operation, the use of the resonance technique overcomes such problem and can make the voltage gain greater than unity.
3. The phase shift at this frequency is small.

Therefore, this "maximum-impedance frequency" can be chosen as the optimal operating frequency of the coreless PCB transformer if input power consumption has to be minimized. At this frequency, the input power requirement of the gate drive is minimized. It should be noted that this operating frequency is not necessarily the switching frequency of the power devices as will be explained further below. The actual switching frequency depends on the type of the gate drive circuits. If a direct gate drive circuit is used the operating frequency is identical to the switching frequency of the power devices. Direct gate drive circuits using the proposed coreless transformers thus are suitable for a few hundreds of kilo-Hertz to Mega-Hertz switching operation. If the desired switching frequency is less than the operating frequency of the coreless transformer, a modulated gate drive circuit can be used.

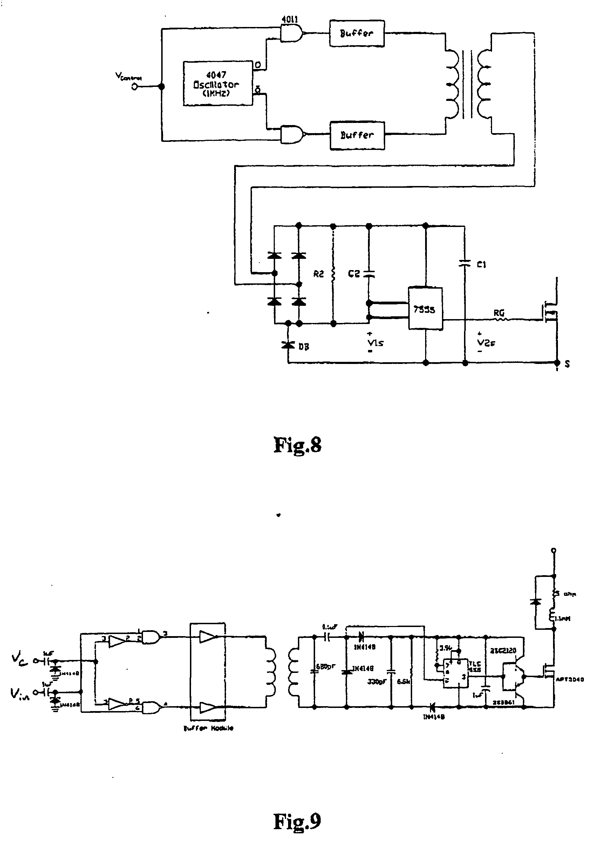

The use of the coreless transformer of Fig.1 in a 'direct' gate drive for operation in the frequency range of a few hundreds of kilo-Hertz and 2 MHz has been described in *Hui et al.* It has been explained above in the prior art that coreless transformers should be operated at high frequency in the Mega-Hertz range (maximum-impedance frequency). However, the switching frequency in many power electronics circuits ranges from a few Hertz to a few hundreds of kilo-Hertz because of the switching loss constraint. The limitation of the direct gate drive is that it cannot be employed efficiently for switching frequency in the low and medium frequency range (say less than 300kHz). In order to design a coreless transformer isolated gate drive which can be switched in low and medium frequency range, the modulated gate drive circuit such as that described in *N.Mohan, T.M.Undeland and W.P.Robbins, Power Electronics: Converters, Applications and Design, Second Edition, John Wiley and Sons Inc, 1995, pp.110-125* can be used. Modulation of a high-frequency carrier by a low-frequency control enables a high-frequency coreless transformer to be used for low frequency switching. Fig.8 shows the simplified schematic of this modulated gate drive that has a smooth transition in the duty cycle from almost zero to one. The energy transfer from the primary side is achieved by the use of a high-frequency carrier signal at the maximum-impedance frequency in the Mega-Hertz range. This minimizes the input current and thus the input power of the gate drive. The control gate signal is coupled to the secondary output by the modulation process.

Based on the concept of the modulated gate drive, a modified gate drive may be provided that operates the overall coreless transformer gate drive in an optimal manner. Aiming at (i) minimizing the input current requirement and (ii) providing a wide range of switching frequency, the modified gate drive circuit and the test circuit consisting of a resistive-inductive load (5Ω and 1.1mH) are shown in Fig.9. The power MOSFET driven by the modified gate drive is APT5040, which has voltage and current ratings of 500V and 16A respectively. A capacitor of 680pF is connected across the secondary winding so that the resonant frequency of the transformer of Fig.4 will be set at about 9.1 MHz. The large stabilizing capacitor of 1μF and the DC blocking capacitor of 0.1μf in the secondary circuit will not significantly affect the frequency characteristic of the transformer because they are in series with a diode (1N4148) which has typical capacitance of only a few pico-Farads. A voltage-doubler is included in the secondary circuit in order to boost the gate drive voltage. The carrier frequency $f_c$ (i.e. the operating frequency) is set at 8 MHz which is the "maximum-impedance frequency" of the transformer. The output signal of the gate drive (i.e. the gate-source voltage $V_{gs}$ of the power MOSFET) is controlled by the input signal $V_{in}$ of the gate drive in the modulation/demodulation process. Thus, the frequency of $V_{in}$ determines the switching frequency ($f_{sw}$) of the power MOSFET.

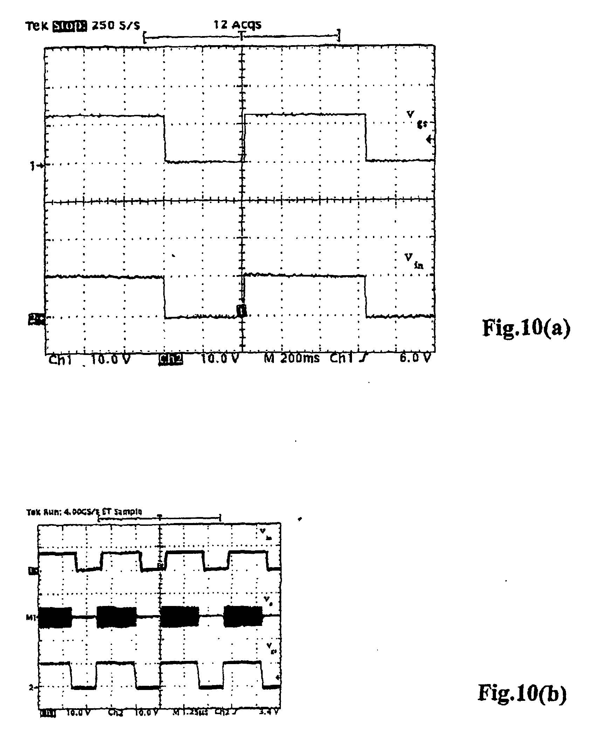

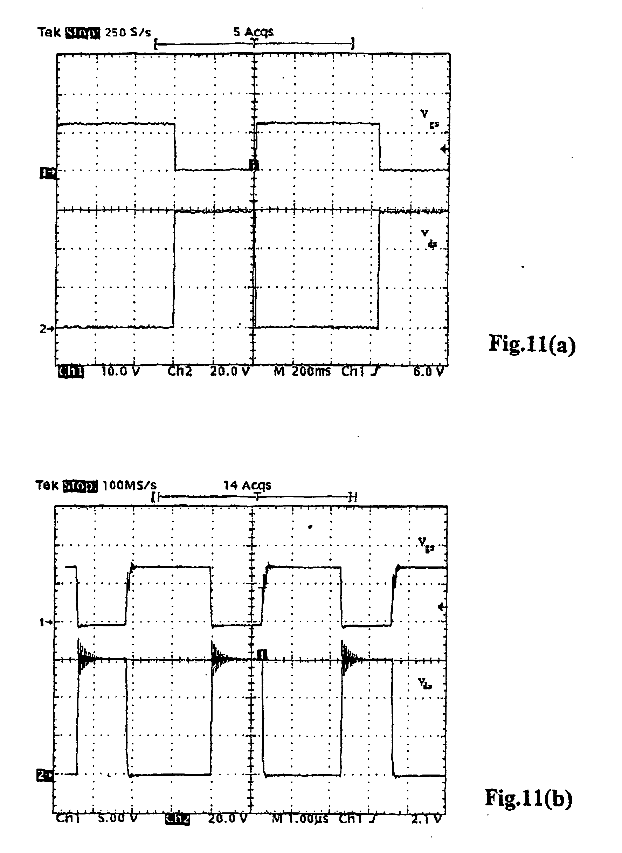

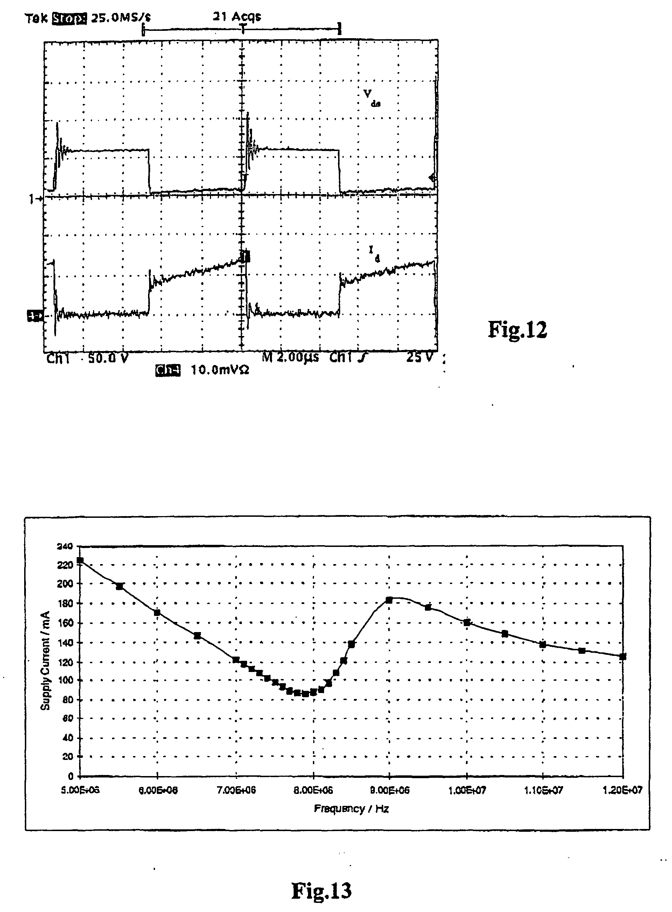

Fig.10a shows the input signal ($V_{in}$) to the gate drive circuit and the gate-source voltage ($V_{gs}$) of the power MOSFET at $f_{sw}$ = 1 Hz. The corresponding waveforms plus the carrier signal ($V_c$) at $f_{sw}$ = 300 kHz are shown in Fig. 10b. The switching waveforms of the gate-source ($V_{gs}$) and drain-source ($V_{ds}$) of the power MOSFET at 1 Hz and 300kHz are shown in Fig. 11a and Fig. 11b, respectively. Typical switching waveforms of the drain-source voltage $V_{ds}$ and drain current $I_d$ of the power MOSFET at a switching frequency of 100kHz are recorded in Fig.12. These practical results confirmed the successful implementation of the coreless transformer of Fig.4 in the modified modulated gate drive circuit. In order to confirm the minimum input power requirement of the driving conditions, the input current of the gate drive circuit under the condition of 100% duty cycle is measured at various carrier frequencies within the useable frequency range. Under 100% duty cycle, the power consumption of the gate drive is at its maximum (i.e. the worst-case situation). The input current versus carrier frequency under such worst case situation is plotted in Fig.13. It can been seen that the input current is minimum at approximately 8 MHz - the "maximum-impedance frequency" of the transformer in the gate drive design. This result confirms the optimal operating conditions of the proposed gate drive design using the coreless PCB transformer. For a dc voltage supply of 10V used in the primary gate drive circuit, the maximum power consumption of the gate drive under the worst condition is less than 0.9 W.

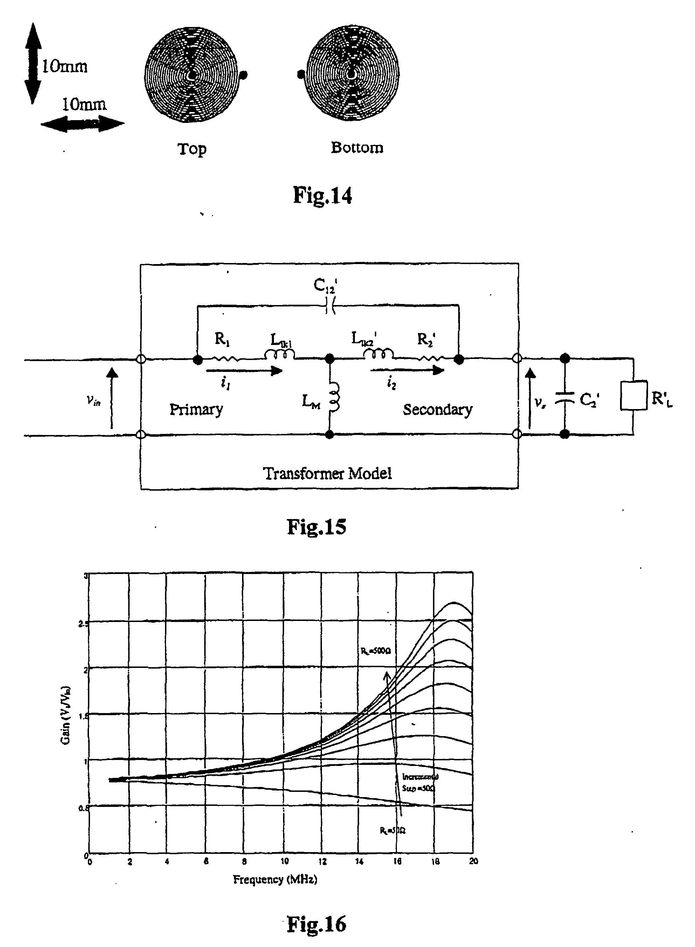

When used for energy transfer (such as in a power converter), the coreless PCB transformer is expected to operate at its maximum energy efficiency conditions. Another coreless PCB transformer (shown in Fig. 14) is used in this analysis. This transformer has 19 turns in the primary winding and 19 turns in the secondary winding. The thickness of the PCB is 0.4mm. The outer radius of the printed winding is about 5.5mm. This transformer has an equivalent circuit as shown in Fig.15. The parameters of the transformer of Fig.14 are $L_{lk1}$=0.35595μH; $L_{lk2}$=0.35595 μH; $L_{M1}$=1,4936 μH. The effect of $C_{12}'$ is neglected in order to simplify the analysis.

Power dissipation of the transformer due to the conductor loss is

$$P_{Loss} = |i_1|^2 \, R_1 + |i_2|^2 \, R_2 \qquad (4)$$

$R_1$ and $R_2$ represent the resistances of the transformer primary and secondary windings, respectively. They are functions of operating frequency due to skin effect. The measured relationships between the resistance and frequency are in the form of Equation (5).

$$R_1 = 1.7819 \times 10^{-15} \, f^2 + 1.8209 \times 10^{-7} \, f + 1.2369 \qquad (5a)$$

$$R_2 = 1.7819 \times 10^{-15} \, f^2 + 1.8209 \times 10^{-7} \, f + 1.2369 \qquad (5b)$$

where $f$ is the operating frequency.
In Equation (4), $i_1$ and $i_2$ are the primary and secondary windings currents respectively.

$$\begin{cases} i_1 = \dfrac{R'_2 + s(L'_{lk2} + L_M) + Z'_L}{[R_1 + s(L_{lk1} + L_M)][R'_2 + s(L'_{lk2} + L_M) + Z'_L] - s^2 L_M^2} v_{in} & ------(6) \\[4mm] i_2 = \dfrac{sL_M}{[R_1 + s(L_{lk1} + L_M)][R'_2 + s(L'_{lk2} + L_M) + Z'_L] - s^2 L_M^2} v_{in} & ------(7) \end{cases}$$

where

$$Z'_L = \frac{1}{sC'_2} \, \| R'_L$$

$$= \frac{R'_L}{1 + sR'_L \, C'_2}$$

Power delivered to the load, $Z_L$, is

$$P_{Load} = \frac{|i_2 Z'_L|^2}{R'_L} = |i_2|^2 \, \frac{|Z'_L|^2}{R'_L} \qquad (8)$$

Energy efficiency of the transformer is defined as

$$\eta = \frac{P_{Load}}{P_{Load} + P_{Poss}} \times 100\% \qquad (9)$$

Put (4), (6), (7) and (8) into (9), then the efficiency of the transformer becomes

$$\eta = \frac{\left|\frac{sL_M R'_L}{1+sR'_L C'_2}\right|^2 \frac{1}{R'_L}}{\left|\frac{sL_M R'_L}{1+sR'_L C'_2}\right|^2 \frac{1}{R'_L} + \left|R'_2 + s(L'_{lk2}+L_M) + \frac{R'_L}{1+sR'_L C'_2}\right|^2 R_1 + \left|sL_M\right|^2 R'_2} \times 100\%$$

$$-----(10)$$

The use of capacitor $C_2$ is to increase the gain ($V_s/V_{in}$), input impedance ($Z_{in}$), and the transformer efficiency ($\eta$). The choice of $C_2$ can also determine the resonant frequency of the transformer circuit. In this analysis, a 100pF capacitor $C_2$ is connected in parallel with the secondary winding of the transformer. The gain ($V_s/V_{in}$), input impedance ($Z_{in}$), and the efficiency ($\eta$), of the transformer versus operating frequency are plotted in Fig.16 to Fig.18, respectively. The load resistance ($R_L$) varies from 50Ω to 500Ω with 50Ω incremental step.

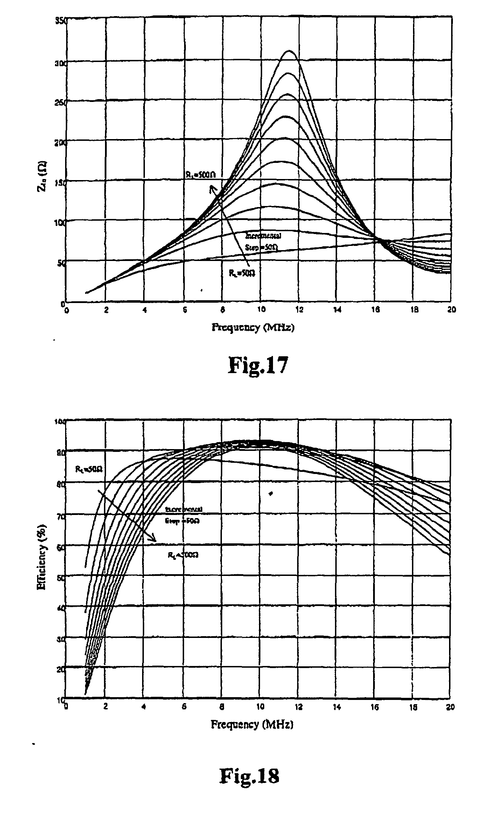

With $C_2$=100pF, Fig.16 shows that the resonant frequency of the transformer of Fig.14 is greater than 15MHz (around 18MHz to 19MHz depending on the load resistance). Fig.17 indicates that the maximum impedance frequency (MIF) occurs at around 11 MHz. The efficiency curves for various load resistances are plotted in Fig.18. It can be seen that the maximum efficiency frequency (MEF) is slightly less than the MIF (around 9MHz to 10MHz). In fact, the transformer can be operated with the frequency range of 8MHz to 11MHz in order to achieve high efficiency (say >90%).

When the load resistance is very large, i.e. load power is very low, the load current and $i_2$ are very small that the power dissipation of the transformer is dominated by $i^2R$ loss component due to the current $i_1$. On the other hand, increasing the transformer input impedance reduces the primary winding curent, $i_1$. Thus, the MEF tends to MIF as the load current is small. For example, power consumption of MOSFET/IGBT gate drive circuits is small enough that the MEF is regarded as the MIF.

When the load resistance decreases, i.e. load power increases, Equation (4) shows that the increasing secondary winding current, $i_2$, will increase the transformer $i^2R$ loss. From Equation (5), the winding resistance increases as operating frequency increases. As a result, operating the transformer in lower frequency can reduce the power loss of the transformer when $i_2$ is significant. As shown in Fig.18, the MEF is below the MIF. MEF increases when the load resistance increases (i.e. the load power decreases).

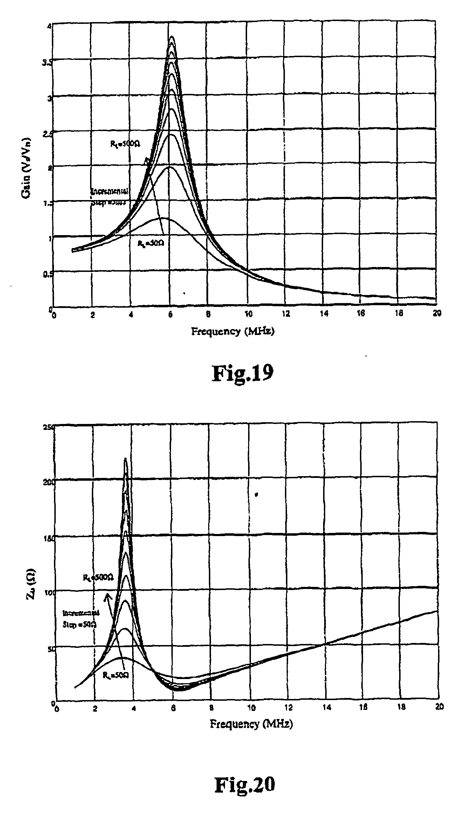

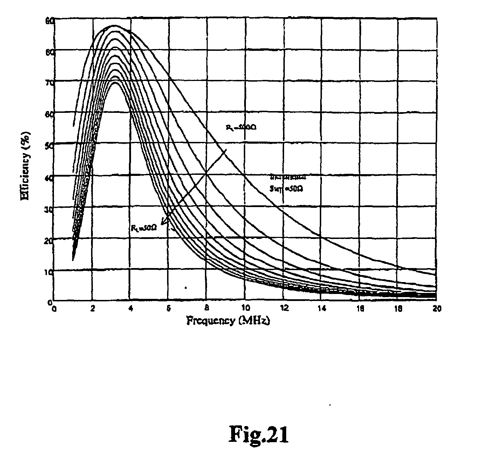

The transformer of Fig.14 is also studied with a larger capacitance $C_2$. As the $C_2$ increases, the voltage gain, resonance frequency, MIF and the MEF decrease. An example with $C_2$=1000pF is used to illustrate the phenomena. Fig.19 to Fig.21 show the frequency response of the gain ($V_s/V_{in}$), input impedance ($Z_{in}$) and the efficiency ($\eta$) of the transformer, respectively. The resonant frequency is now set at about 6MHz. The MIF is about 3.8MHz and the MEF is about 3.2MHz. Thus, the coreless PCB transformer, when used in a power converter, should be operated at the MEF (which is lower than the MIF) in order to achieve maximum energy efficiency.

It will thus be seen that optimal operating techniques for using a coreless PCB transfomer under (1) minimum input power requirement and (2) maximum energy efficiency have been described above. The optimal operation of a coreless PCB transformer in an isolated gate drive circuits for power MOSFET/IGBT devices has been successfully demonstrated for a wide frequency range from 1 Hz to 300 kHz. Criteria for selecting the optimal operating conditions for the coreless transformer in gate drive (energy and signal transfer) applications are developed, presented and experimentally verified. It is found that coreless transformers should be operated at or near their "maximum-impedance frequencies" so that the input power requirement can be minimized and the voltage gain is high. This optimal operating condition of the coreless transformer has been demonstrated in the "modulated" gate drive circuit and can also be applied to the "direct" gate drive. For both types of isolated gate drive circuits, the operating frequency of the transformers are always chosen to their "maximum-impedance frequencies". For the modulated transformer-isolated gate drive circuit, the carrier frequency of the transformer circuit is chosen to be the maximum-impedance frequency of the transformer. The transmitted signal demodulation process. For the direct gate drive, the signal is simply transmitted at the maximum-impedance frequency of the transformer. The choice of optimal operating frequency of the transformer circuit can be very flexible because the resonant frequency and thus the maximum-impedance frequency of the transformer circuit can be precisely determined by the size of the external capacitor $C_2$. Procedures for selecting the parameters for the modulated gate drive have also been described above. When used with coreless transformers, direct gate drives are found to be suitable for high (Mega-Hertz) switching frequency. The modulated gate drive should be used for low and medium (say less than 300kHz) switching operation. The size of the new coreless transformer of Fig. 4 is about 25% of that of a previously known transformer and is much smaller than that of a typical core-based high-frequency pulse transformer in terms of both area and volume.

When used for electrical energy transfer such as in a power converter, the coreless PCB transformers should be operated at or near their maximum efficiency frequency (MEF) which is found to be lower than the maximum impedance frequency (MIF).

Coreless transformers are cheaper than core-based transformers. They eliminate the requirements of magnetic core and manually-wound transformers. Consequently, automation in the manufacturing process of gate drive circuits becomes feasible and the manufacturing cost can be reduced. In conclusion, it is demonstrated that magnetic core is not a necessary item in transformer isolated gate drive circuits. The same idea can, in principle, be applied to low-power converters. Coreless PCB transformers are particularly suitable for use in applications in which stringent height requirements have to be met.

## Claims

1. A method of operating a coreless planar transformer, **characterized in that** said transformer is operated at an optimum frequency which is at or near the frequency at which the impedance of a transformer equivalent circuit is at its maximum and which is less than the resonant frequency of the transformer.

2. A method as claimed in claim 1 wherein the transformer is operated at a frequency of between 100kHz and 20Mhz.

3. A method as claimed in claim 1 or 2 wherein said transformer is operated by a high-frequency carrier signal modulated by a low-frequency switching signal, said carrier signal being at said optimum frequency.

4. A method as claimed in claim 3 wherein said switching signal is at a frequency of less than 300kHz.

5. A method of driving a gate of a power MOSFET or IGBT device comprising isolating said gate from a power supply by means of a coreless planar transformer and driving said gate at an optimum frequency which is at or near the frequency at which the impedance of a transformer equivalent circuit is at its maximum and which is less than the resonant frequency of the transformer.

6. A method as claimed in claim 5 wherein said gate is driven at a frequency in the range of from about 100kHz to 20MHz.

7. A method as claimed in claim 5 or 6 wherein a low frequency switching signal is used to modulate a high-frequency carrier signal input to said transformer, and wherein said carrier signal is demodulated after said transformer to drive said gate at said low switching frequency, said carrier signal being at said optimum frequency.

8. A method as claimed in claim 7 wherein said switching signal is at a frequency of less than 300kHz.

## Patentansprüche

1. Verfahren zum Betreiben eines kernlosen planaren Transformators, **dadurch gekennzeichnet, dass** der Transformator mit einer optimalen Frequenz, die gleich oder nahe der Frequenz, bei der die Impedanz einer Transformator-Äquivalentschaltung ihr Maximum hat und die geringer als die Resonanzfrequenz des Transformators ist, betrieben wird.

2. Verfahren nach Anspruch 1, wobei der Transformator bei einer Frequenz zwischen 100kHz und 20MHz betrieben wird.

3. Verfahren nach einem der Ansprüche 1 oder 2, wobei der Transformator durch ein mit einem niederfrequenten Schaltsignal moduliertes hochfrequentes Trägersignal betrieben wird, wobei das Trägersignal die optimale Frequenz hat.

4. Verfahren nach Anspruch 3, wobei das Schaltsignal eine Frequenz von weniger als 300kHz hat.

5. Verfahren zum Ansteuern eines Gates eines Leistungs-MOSFET oder IGBT Bauelementes, wobei das Gate von einer Speisung durch einen kernlosen planaren Transformator isoliert wird und das Gate bei einer optimalen Frequenz, die gleich oder nahe der Frequenz, bei der die Impedanz einer Transformator-Äquivalentschaltung ihr Maximum hat und die geringer als die Resonanzfrequenz des Transformators ist, betrieben wird.

**6.** Verfahren nach Anspruch 5, wobei das Gate mit einer Frequenz im Bereich zwischen 100kHz und 20MHz angesteuert wird.

**7.** Verfahren nach Anspruch 5 oder 6, wobei ein niederfrequentes Schaltsignal zum Modulieren eines hochfrequenten am Transformator anliegenden Trägersignals genutzt wird, und wobei das Trägersignal nach dem Transformator zum Ansteuern des Gates mit der niederfrequenten Schaltfrequenz demoduliert wird, wobei das Trägersignal die optimale Frequenz hat.

**8.** Verfahren nach Anspruch 7, wobei das Schaltsignal eine Frequenz von weniger als 300kHz hat.

**Revendications**

**1.** Procédé d'utilisation d'un transformateur plan sans noyau, **caractérisé en ce que** ledit transformateur est utilisé à une fréquence optimale qui est à ou proche de la fréquence à laquelle l'impédance d'un circuit équivalent au transformateur est à son maximum, et qui est inférieure à la fréquence de résonance du transformateur.

**2.** Procédé selon la revendication 1, dans lequel le transformateur est utilisé à une fréquence comprise entre 100 kHz et 20 MHz.

**3.** Procédé selon la revendication 1 ou 2, dans lequel ledit transformateur est utilisé au moyen d'un signal porteur haute fréquence modulé par un signal de commutation basse fréquence, ledit signal porteur étant à ladite fréquence optimale.

**4.** Procédé selon la revendication 3, dans lequel ledit signal de commutation est à une fréquence inférieure à 300 kHz.

**5.** Procédé de commande d'une porte d'un dispositif MOSFET ou IGBT de puissance, comprenant l'isolation de ladite porte vis-à-vis d'une alimentation électrique au moyen d'un transformateur plan sans noyau et la commande de ladite porte à une fréquence optimale qui est à ou proche de la fréquence à laquelle l'impédance d'un circuit équivalent au transformateur est à son maximum, et qui est inférieure à la fréquence de résonance du transformateur.

**6.** Procédé selon la revendication 5, dans lequel ladite porte est commandée dans une plage de fréquence comprise environ entre 100 kHz et 20 MHz.

**7.** Procédé selon la revendication 5 ou 6, dans lequel un signal de commutation basse fréquence est utilisé pour moduler un signal porteur haute fréquence en entrée dudit transformateur, et dans lequel ledit signal porteur est démodulé après ledit transformateur afin de commander ladite porte à ladite basse fréquence de commutation, ledit signal porteur étant à ladite fréquence optimale.

**8.** Procédé selon la revendication 7, dans lequel ledit signal de commutation est à une fréquence inférieure à 300 kHz.

Primary (Top)          Secondary (Bottom)

**Fig.1**

**Fig.2**

**Fig.3(a)**

11

**Fig.3(b)**

**Fig.4**

**Fig.5**

**Fig.6**

**Fig.7(a)**

**Fig.7(b)**

Fig.8

Fig.9

Fig.10(a)

Fig.10(b)

Fig.11(a)

Fig.11(b)

Fig.12

Fig.13

**Fig.14**

**Fig.15**

**Fig.16**

**Fig.17**

**Fig.18**

**Fig.19**

**Fig.20**

**Fig.21**